# EUROPEAN PATENT APPLICATION

(11) **EP 1 708 321 A1**
(43) Date of publication of application: **04.10.2006**
(21) Application number: 04805088.4
(22) Date of filing: 03.12.2004
(51) Int. Cl.: H01S 3/16

(54) **THIN SINGLE CRYSTAL FILMS OF DOUBLE WOLFRAMATE COMPRISING POTASSIUM-YTTRIUM, LUTETIUM OR GADOLINIUM PARTIALLY SUBSTITUTED WITH YTTERBIUM**

(30) Priority: 05.12.2003 ES 200302881
(71) Applicant: Universitat Rovira I Virgili, E-43007 Tarragona (ES)
(72) Inventor: DIAZ GONZALEZ, Francesc, E-43007 TARRAGONA (ES); AZNAR ECIJA, Ana, E-43007 TARRAGONA (ES); SOLE CARTANA, Rosa, E-43007 TARRAGONA (ES); AGUILO DIAZ, Magdalena, E-43007 TARRAGONA (ES)
(74) Representative: Carpintero Lopez, Francisco
(86) International application number: PCT/ES2004/000545
(87) International publication number: WO 2005/057742

(57) **Abstract**

The invention relates to thin monocrystalline layers of potassium yttrium/lutetium/gadolinium double tungstate partially substituted with ytterbium and to its application in the manufacturing of waveguides and thin-disk lasers. It also discloses the method for the growth of said layers on previously produced monocrystalline substrates.

## Description

### FIELD OF THE INVENTION

This invention relates to thin monocrystalline layers of potassium yttrium double tungstate partially substituted with ytterbium, as well as to the process for its production and to its application for the manufacturing of waveguides and thin-disk lasers.

### BACKGROUND OF THE INVENTION

At present, research in laser technology is mainly focused on the development of lasers which emit increasingly small wavelengths, which means that the photons have greater energy. Interest in producing green and blue-emitting lasers are mainly focused on the greater visual acuteness the human eye has for these wavelengths, in addition to favouring the miniaturization of the equipment which use this type of lasers. Ytterbium is particularly interesting due its emission at a wavelength close to 1 micron with a small quantum defect and the absence of up-conversion, cross-relaxation and quenching (concentration which produces a blocking of the emission) processes. Furthermore, its broad absorption bands enable efficient pumping with high-power InGaAs laser diodes. The small Stokes' flow between emission and absorption reduces the thermal load of the material and increases laser efficiency.

Potassium yttrium double tungstate allows the partial substitution of yttrium for ytterbium conserving the same crystalline structure and forming a solid solution which goes from potassium yttrium tungstate, passing through the different intermediate degrees of substitution of yttrium for ytterbium, until arriving at potassium ytterbium tungstate. This allows this material to be produced with the most appropriate substitution level for each application. The behaviour is the same in the case of potassium lutetium double tungstate or potassium gadolinium double tungstate.

Ytterbium-doped potassium yttrium/lutetium/gadolinium double tungstate is particularly interesting due to the high value of its effective absorption and emission sections. These materials are very anisotropic, presenting the maximum absorption for a wavelength of close to 981 nanometres, the maximum absorption for polarized light parallel to the direction of the main Nₘ optic axis which is around 15 times greater than that of YAG:Yb, being very widely commercially used. In addition to double tungstates, Yb has the smallest quantum defect that has been found up to the present time.

The high effective absorption section of potassium yttrium/lutetium/gadolinium double tungstate partially substituted with ytterbium (KY₁₋ₓYbₓ(WO₄)₂, KLu₁₋ₓYbₓ(WO₄)₂ or KGd₁₋ₓYbₓ(WO₄)₂) would make the use of very thin crystalline layers possible in order to be able to miniaturize the devices. In particular, this material would be of great interest for the manufacturing of waveguides and thin-disk lasers.

In this regard, the authors of the present invention have been capable of producing high-quality thin monocrystalline layers of potassium yttrium double tungstate partially substituted with ytterbium based on the Liquid Phase Epitaxy technique (hereinafter, LPE).

The LPE technique, unlike other techniques used to produce thin layers, enable the production of homogeneous, high-quality thin microcrystalline layers of the material of interest on a substrate, allowing the thickness to be controlled by adjusting the oversaturation of the solution used for the growth and the growth time. Nevertheless, said technique poses several technical problems that the inventors of the present application have resolved such as the choice of substrate, determining the suitable composition of the growth solution, obtaining the suitable temperature gradient for the correct growth, determining the suitable time and temperature conditions to produce high-quality layers with a desired thickness or producing a suitable angular rotation rate.

### SUMMARY OF THE INVENTION

The present invention faces the problem of producing homogenous thin monocrystalline layers of a material that, containing a sufficient quantity of ytterbium (or another lanthanide), enables the manufacturing of waveguides and thin-disk lasers which facilitate the miniaturization of the equipment with high efficiency.

The solution provided by this invention is based on the use of the LPE technique, for the growth of thin monocrystalline layers of potassium yttrium/lutetium/gadolinium (or another lanthanide) double tungstate with different substitutions of yttrium, lutetium or gadolinium for ytterbium (or another lanthanide) on potassium yttrium/lutetium/gadolinium (or another lanthanide) double tungstate substrates, previously produced from a high-temperature solution.

It is important to mention that the thin monocrystalline layers of the present invention have the advantage of possessing layer thicknesses of just a few tens of microns, which meets the demands of equipment the current market requires.

Therefore, an object of the present invention is high-quality thin monocrystalline layers of potassium yttrium (or a lanthanide such as lutetium or gadolinium) double tungstate, partially substituted with ytterbium (or another lanthanide) with a thickness which varies from a few microns up to several tens of microns.

An additional object of the invention is the process used to produce said thin monocrystalline layers.

Another additional object of the invention is the use of the thin monocrystalline layers of the invention for manufacturing waveguides and miniaturized thin-disk lasers.

### BRIEF DESCRIPTION OF THE FIGURES

- **Figure 1**: shows the solubility curves of potassium yttrium double tungstate and potassium ytterbium double tungstate in the solvent K₂W₂O₇.
- **Figure 2**: shows the axial thermal profile inside the oven used to grow thin layers using the LPE technique.
- **Figure 3**: shows the morphology of a single-crystal of KY(WO₄)₂, KLu(WO₄)₂ or KGd(WO₄)₂.
- **Figure 4**: shows the change in the concentration of Y and Yb on crossing the epitaxy substrate/layer interface. Inserted in the same figure is a photograph made with the scanning electronic microscope (SEM) of said interface, by the use of back-scattered electrons.
- **Figure 5**: shows the thickness of the epitaxial layer of KY_{0.9}Yb_{0.1}(WO₄)₂ produced on the surface {010} of a substrate of KY(WO₄)₂ in accordance with time, for a same level of solution oversaturation.
- **Figure 6**: shows the total internal reflection process of a waveguide.
- **Figure 7**: shows a diagram of the experimental device used for the laser experiments of the epitaxial layer.

### DETAILED DESCRIPTION OF THE INVENTION

In a first aspect, the invention provides high-quality thin monocrystalline layers of a double tungstate of formula KA_{1-X} Bₓ(WO₄)₂ wherein A represents yttrium, lutetium or gadolinium (or another lanthanide), B represents a lanthanide preferably ytterbium, and x represents a percentage of atom substitution which varies between 0 and 0.5.

According to the present invention, thin monocrystalline layer refers to those monocrystalline layers whose thickness is between one micron and approximately one hundred microns.

High-quality thin monocrystalline layers refer to those transparent epitaxial layers, free from inclusions and fractures which may be observed under the microscope up to approximately 50x magnification.

In a particular embodiment, the monocrystalline layers of the present invention have a composition which is represented by the formula KY_{0.9}Yb_{0.1}(WO₄)₂. In another particular embodiment the monocrystalline layers have a composition represented by a formula KY_{0.8} Yb_{0.2} (WO₄)₂.

A second aspect of the invention relates to the process to produce the aforementioned thin monocrystalline layers. This process has the following stages:
a) producing a crystal which serves as monocrystalline substrate for epitaxial growth and cleaning it,
b) preparing a growth solution of double tungstate of formula KA_{1-X} B_{X}(WO₄)₂ dissolved in K₂W₂O₇, preferably in the solute/solvent proportion of 5/95 and subjecting it to a practically zero thermal axial gradient in a free-standing growth oven,
c) immersing the crystal of stage a), previously reheated, in the growth solution of stage b), which is found at a temperature slightly above that of saturation.
d) decreasing the temperature of the solution to produce epitaxial growth, so that high-quality thin monocrystalline layers are obtained.

Stage a) involves a step prior to the growth process of the thin monocrystalline layers. In said stage a monocrystalline substrate is produced whereon the epitaxial growth of the thin layers object of the invention will be performed. Said monocrystalline substrate may be KY(WO₄)₂, KLu(WO₄)₂ or KGd(WO₄)₂. The most appropriate method for its production is seed growth from the concentrated solution (TSSG, Top Seeded Solution Growth). This method comprises three basic stages:
i) preparing a growth solution for the substrate and subjecting it to an axial thermal gradient of, preferably, 1 K/cm in an oven,
ii) introducing a crystal seed in the solution of stage i) at a temperature slightly higher than the expected saturation temperature,
iii) gradually cooling the solution at a set rate, from the saturation temperature obtained, so that the crystal grows.

The most appropriate solvent to prepare the growth solution of step i) is K₂W₂O₇, as it offers the advantage of in addition to not containing ions outside the crystals to be produced, its melting temperature is low compared with that of other compounds belonging to the K₂O-WO₃ system. Another additional advantage of this solvent is that it provides low viscosity values to the KY(WO₄)₂, KLu(WO₄)₂ or KGd(WO₄)₂ solutions. On the other hand, the reagents necessary for the monocrystal to grow, which will act as a substrate for the epitaxial growth of the thin layers, are K₂CO₃, Y₂O₃ (or Lu₂O₃ or Gd₂O₃) and WO₃. These reagents must preferably be used in suitable proportions to achieve a molar ratio between the (KY(WO₄)₂, KLu(WO₄)₂ or KGd(WO₄)₂) solute and the (K₂W₂O₇) solvent of 12/88.

Before proceeding with the slow cooling of the solution for crystal growth as is explained in step iii), it is necessary to determine the real saturation temperature of the solution. To do this, after homogenizing the solution at a temperature of approximately 50 K above the expected saturation temperature, it is necessary to observe the growth/dissolution of a crystal seed of KY(WO₄)₂, KLu(WO₄)₂ or KGd(WO₄)₂ in contact with the solution, by temperature variations.

In a particular embodiment, the growth of the crystal is achieved by cooling the solution from the real saturation temperature determined, until approximately 10-12 K below it, at a rate of 0.1 K/h during the reduction of the first two degrees, to later be fixed at a rate of 0.05 K/h until decreasing by the desired degrees. The orientation of the crystals which gives best results is that of crystallographic direction b perpendicular to the solution surface. During the single-crystal growth process, it is necessary to provide it with a rotation movement. In a particular embodiment the single-crystal is given an angular velocity of 40 rpm.

Once the single-crystal has formed, it is recommendable to slowly remove it from the solution, leave it a few millimetres above the solution surface and cool it at a rate of 15 K/h to minimize the thermal shocks and thus avoid fractures due to quick cooling. These crystals can later be used just as they come out of the oven or cut into sheets, as substrates for the epitaxial growth of the thin monocrystalline layers object of the present application.

A very important step, prior to the epitaxial growth, is cleaning the substrates which is achieved by immersing them for approximately 5 minutes in HNO₃:H₂O, another 5 minutes in C₂H₅-OH and finally another 5 minutes in distilled water. It is cleaned in rotation to favour the interaction between the cleaning liquid and the crystal.

Once the substrate is produced, it is possible to perform the actual epitaxial growth.

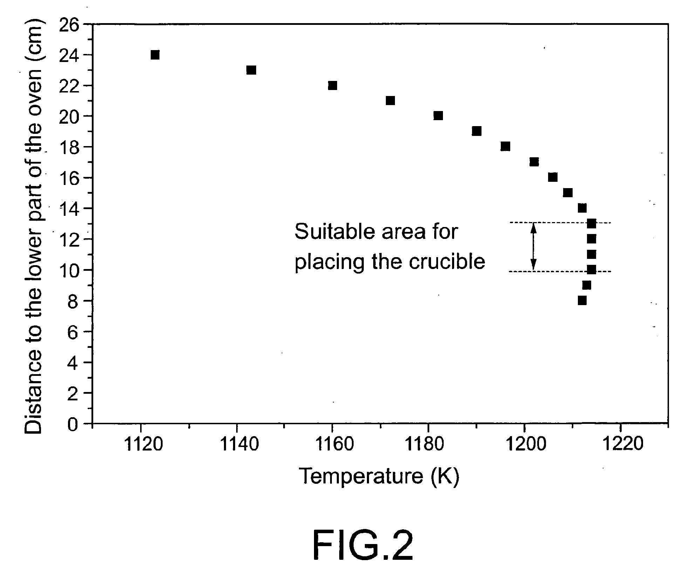

To correctly achieve epitaxial growth, an essential premise is to obtain a practically zero axial gradient in the solution of stage b). Figure 2 shows the appropriate axial thermal profile in the growth oven, as well as the most correct positioning of the crucible therein, so that the correct growth of the thin monocrystalline layers of the invention occurs.

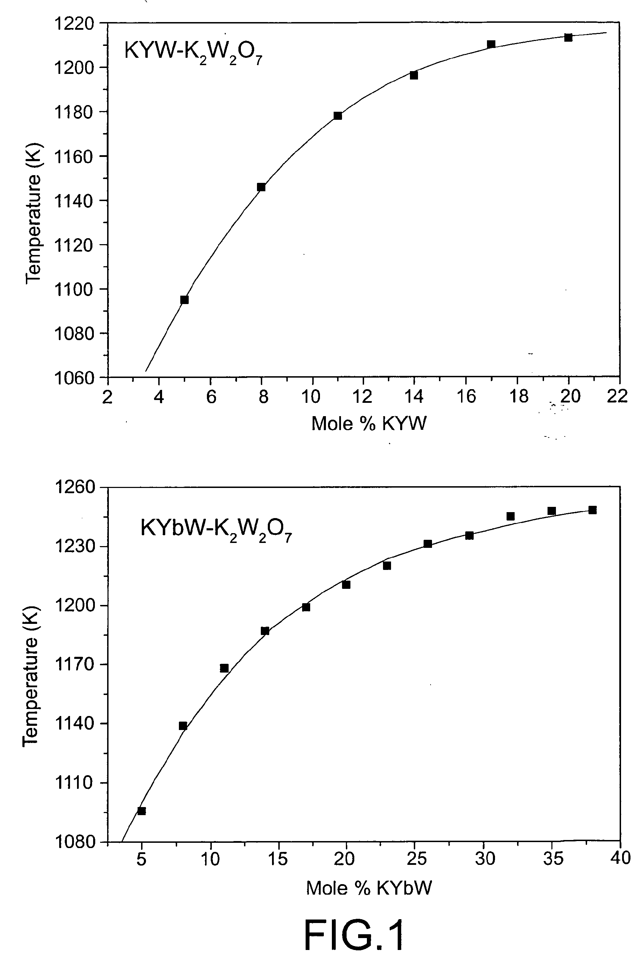

The recommended composition to perform the epitaxial growth is with a low solute content, since, taking into account the solubility curves of KY(WO₄)₂, KLu(WO₄)₂, KGd(WO₄)₂) and KYb(WO₄)₂ in solvent K₂W₂O₇ (see figure 1), decreasing the concentration of the solute increases the gradient of these solubility curves, lowering the growth temperature. This allows a better control of epitaxial growth, since by decreasing the solution temperature by 1 K, the oversaturation which occurs is less than for high concentrations. Furthermore, growth at very low temperatures has the advantage that it reduces the possibility that stresses occur in the crystal, which may contribute to the appearance of fractures therein. For this reason, in the preferred embodiment of the invention the molar solute/solvent proportions are 5/95. In a particular embodiment, the solute used for the growth is KY_{1-X}Yb_{X}(WO₄)₂ preferably x = 0.2.

As with the substrate growth, it is necessary to calculate the saturation temperature of the solution of stage b) before starting the epitaxial growth. Thus, after homogenizing the solution during several hours at a temperature 50 K above that of the expected saturation, the same is performed as in the case of the substrate growth. Likewise, it is recommended to perform a study of the growth/dissolution kinetics of a crystal seed positioned in contact with the solution surface for different temperatures close to that of the solution saturation. With this information, the temperature at which the epitaxial growth will be performed can be decided, as well as the growth time, for a determined layer thickness to be produced.

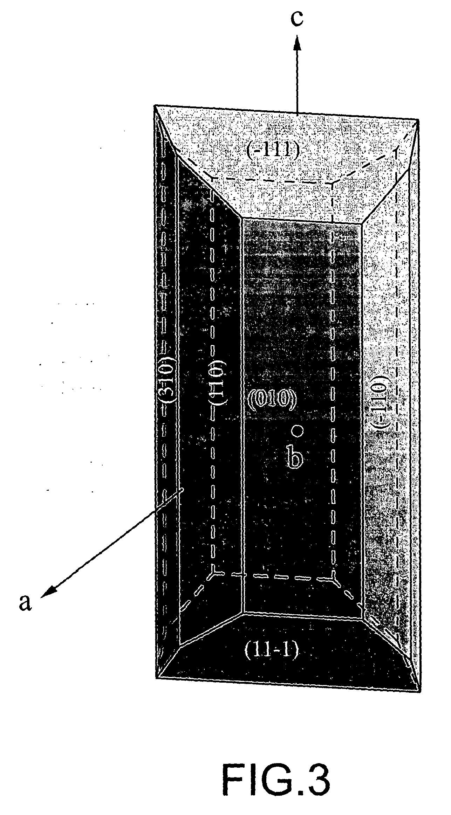

For a suitable epitaxial growth, the crystal is immersed in the growth solution in accordance with stage c), at a temperature slightly above that of the saturation in order to dissolve the outermost layers of the crystal, and approximately five minutes later, and in accordance with stage d), the solution temperature is decreased until the temperature wherein the growth occurs which is normally between 1-2 K below the saturation temperature. Throughout the experiment, the crystal is kept rotating, with an angular velocity of preferably 40 rpm. Depending on the thickness of the monocrystalline layer to be achieved on the different crystalline surfaces, the growth will be performed for 1-4 hours. It has been verified that although high-quality epitaxial growth is obtained on all layers, the epitaxial layers produced on the surfaces {010}(see Figure 3) are those with highest quality. Table 1 shows the thickness of the epitaxial layer produced using this growth technique and the growth rate for different crystalline surfaces, the growth conditions being the same for all surfaces.

**Table 1: Thickness of the epitaxial layer produced from the liquid phase and its growth rate on different crystalline surfaces.**

| Surface | Thickness (microns) | Growth rate (microns/h) |
|---|---|---|
| {010} | 48.1 | 12 |
| {110} | 29.9 | 7.5 |
| {310} | 8.0 | 2 |

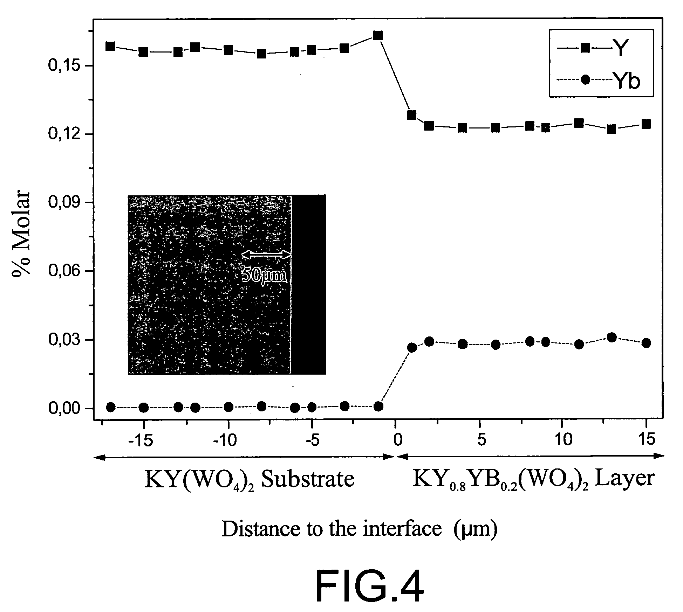

It has also been verified, by performing an electron probe microanalyzer (EPMA), that there is no diffusion of ytterbium from the epitaxial layer to the substrate. The result of this analysis, performed around the substrate/epitaxial layer interface, can be observed in figure 4. The same figure also shows a photograph made with the electronic scanning microscope using back-scattered electrons and where it is clearly observed that there is a sudden composition change when the substrate/epitaxial layer interface is crossed.

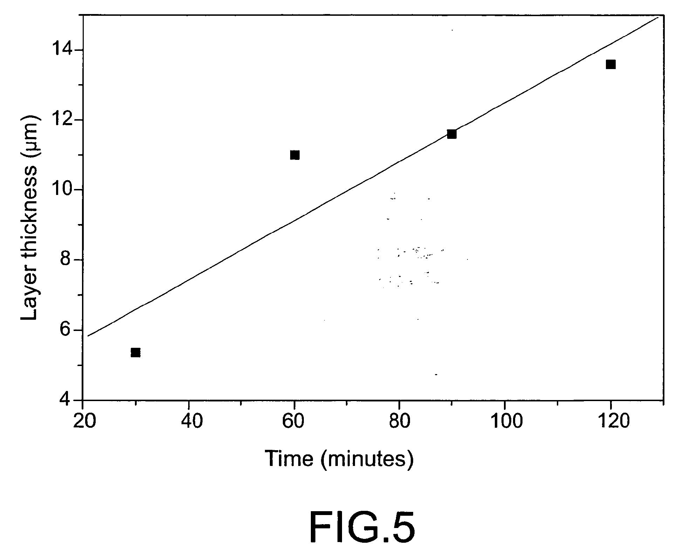

Since the epitaxial growth which has the best crystalline quality is that performed on surface {010}, the inventors studied the variation in thickness of the epitaxial layer on this surface with the growth time. To do this, they used a substrate in the form of a sheet cut from a large crystal, so that it was polished in the cutting area. It was observed that the epitaxial growth on a natural surface always had a superior quality than that performed on a polished surface, for which reason it is recommendable to perform the epitaxial growth in accordance with the present invention on a natural surface. The study of the variation in thickness is shown in figure 5 wherein it can be observed that there practically exists a linear behaviour between the thickness of the grown layer and the growth time, for times in the order of those studied in the present invention.

The last aspect of the invention relates to the use of high-quality thin monocrystalline layers of potassium yttrium/lutetium/gadolinium (or another lanthanide) double tungstate partially substituted with ytterbium (or another lanthanide) for the manufacturing of waveguides and thin-disk lasers.

The authors of the present invention have lasered, for the first time, an epitaxial layer of KY_{0.8} Yb_{0.2} (WO₄)₂ of approximately 25 microns thickness grown by the LPE technique on a KY(WO₄)₂ substrate. The lasering was performed by a continuous wave with 15% efficiency with respect to the absorbed power.

The following examples illustrate the invention.

### Example 1: Substrate preparation

The preparation of substrates for the later performance of epitaxial growth experiments has been performed in a free standing cylindrical oven with Kanthal wire resistance. Temperature control has been performed using a Eurotherm 903 P controller/programmer connected to a thyristor. The temperature information on the resistance has been obtained using an S-type thermocouple (Pt/ Pt-10%Rh).

The following chemical products have been used for the formation of the growth solution: K₂CO₃, Y₂O₃ and WO₃ with 99.9 % purity. For the growth of substrates, a 125 cm³ cylindrical platinum crucible, with a diameter of 50 mm has been used.

In the particular experiment to produce substrates detailed, a solution composition with a molar ratio KY(WO₄)₂ / K₂W₂O₇ = 12/88 has been used. In particular, for the formation of the solution 0.0436 moles of KY(WO₄)₂ and 0.32 moles of K₂W₂O₇ have been used, which gives the number of moles of each of the reagents which is detailed below:

| | K₂CO₃ | Y₂O₃ | WO₃ |
|---|---|---|---|
| Solute [KY(WO₄)₂] | 0.0218 | 0.0218 | 0.0872 |
| Solvent [K₂W₂O₇] | 0.32 | | 0.64 |
| Total | 0.3418 | 0.0218 | 0.7272 |

Using this number of moles, a quantity of solution of little more than 205 grams has been produced.

With this solution composition, the saturation temperature obtained has been around 1175 K. After this temperature, the solution temperature was decreased at a rate of 1 K/h until decreasing the solution temperature 2 K, to then reduce the solution cooling rate to 0.05 K/h until the solution temperature was decreased a further 8 K. Then, the slow extraction of the crystal has been performed until losing contact with the growth solution. Finally, with the crystal positioned approximately 2 mm above the solution surface, the oven has been cooled at a rate of 15 K/h until reaching ambient temperature, thus avoiding the possible formation of fractures in the crystal due to thermal shocks.

The substrate produced has been of optimum quality for the later performance of epitaxial growth experiments.

### Example 2: production of thin monocrystalline layers of KY_{0.9}Yb_{0.1}(WO₄)₂

The growth of thin monocrystalline layers by the LPE technique has been performed in an oven, of Kanthal resistance, especially designed so that the central area has a practically zero thermal gradient. The temperature control has been performed, the same as in the substrate growth experiments, using a Eurotherm 903 P controller/programmer connected to a thyristor. The temperature information on the resistance has been obtained using an S-type thermocouple (Pt / Pt-10%Rh).

The reagents used for the formation of the solution have been the same as for the substrate growth and, furthermore Yb₂O₃, used for the partial substitution of Y for Yb. To perform epitaxial growth, a 25 cm³ cylindrical platinum crucible, with a diameter of 30 mm has been used.

In the particular experiment to produce epitaxial growth which is detailed, a solution composition with a molar ratio KY_{0.9}Yb_{0.1}(WO₄)₂ / K₂W₂O₇ = 5 / 95 has been used. In particular, for the solution formation, 6,3158.10⁻³ moles of KY(WO₄)₂ and 0.12 moles of K₂W₂O₇ have been used, which gives the number of moles of each of the reagents.which is detailed below:

| | K₂CO₃ | Y₂O₃ | Yb₂O₃ | WO₃ |
|---|---|---|---|---|
| Solute [KY(WO₄)₂] | 3.1579.10⁻³ | 2.8421.10⁻³ | 3.1579.10⁻⁴ | 12.6316.10⁻³ |
| Solvent [K₂W₂O₇] | 0.12 | | | 0.24 |
| Total | 0.1231579 | 2.8421.10⁻³ | 3.1579.10⁻⁴ | 0.2526316 |

Using this number of moles, little more than 70 grams of solution has been produced. Next, the solution saturation temperature has been precisely determined using a KY(WO₄)₂ seed. The solution growth/ dissolution rate has also been studied as a function of the temperature, to be able to decide the temperature and the performance time of epitaxial growth. The saturation temperature produced in this case has been 1098 K.

Prior to performing epitaxial growth and producing a high-quality thin layer, it is necessary to clean the substrate. This is performed by maintaining for approximately 5 minutes in HNO₃:H₂O, another 5 minutes in C₂H₅-OH and finally another 5 minutes in distilled water. It is cleaned in rotation to favour the interaction between the cleaning liquid and the crystal.

Next, the substrate is slowly introduced in the oven where the thin monocrystalline layer will be grown. It is slowly introduced to avoid thermal shocks which may contribute to the formation of fractures in the crystal. Once the crystal is introduced in the oven, it is maintained at least 30 minutes in a position slightly above the solution surface so that when it is introduced in the solution it is at the same temperature as the solution. The crystal is then introduced in the solution until it is immersed therein, the solution temperature being 1 K above its saturation temperature, in the particular experiment detailed. The solution is maintained at this temperature during 5 minutes in order to dissolve the outermost layer of crystal before starting epitaxial growth. Next, in this particular experiment, the temperature solution is decreased to 2 K below its saturation temperature, maintaining the crystal immersed in the solution at this temperature during 2 hours. Throughout the thin monocrystalline layer growth experiment, the crystal has been maintained in rotation, rotating at 40 rpm.

Next, the crystal is extracted from the solution and is subsequently extracted from the oven also done very slowly, to avoid sharp temperature changes which may produce fractures in the crystal.

In this particular experiment, the quality of the epitaxial layer produced on the different crystalline surfaces had an optimum quality for the later scientific research to be performed with said crystal.

### Example 3: applications

The monocrystalline layers produced by the technique described in the previous example are of suitable quality to be used in the waveguide process and also in manufacturing minilasers.

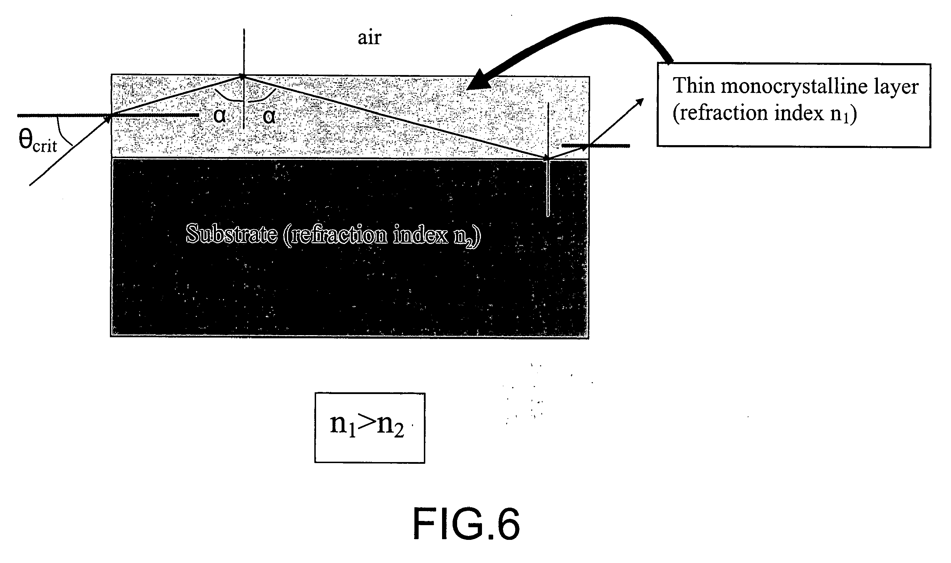

The light guiding process in a waveguide is based on the total internal reflection process. To this end, there should exist an interface between two means with a different refraction index, so that the light is diffused by the means with greater refraction index. This interface is achieved in the separation between the substrate and thin monocrystalline layer. The process is performed according to the diagram of figure 6. When the angle of incidence in the monocrystalline layer (angle the incident light forms with respect to the normal to said layer) is less than a certain limit value, the light is diffused by the interior of the layer performing internal total reflections with minimum losses.

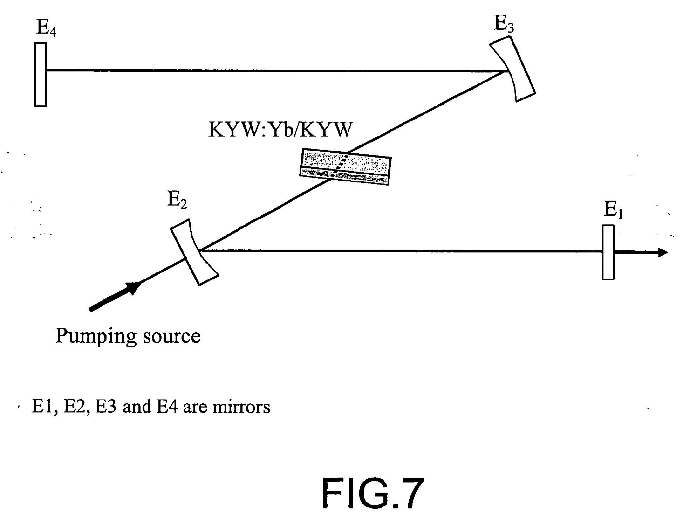

Another application of interest of the thin monocrystalline layers of these ytterbium-doped materials is the manufacturing of minilasers. This is possible due to the high effective absorption section of ytterbium-doped potassium yttrium/lutetium/gadolinium double tungstates. High absorption is achieved with a small thickness of the epitaxial layer, achieving the population investment necessary for the emission of laser radiation. This is achieved when said electrons fall at the fundamental level by stimulated emission, producing radiation which, after an amplification process, is that which is known as laser radiation. A example of possible laser cavity which incorporates the epitaxial material is shown in figure 7

## Claims

1. High-quality thin monocrystalline layers of a double tungstate of formula KA_{1-X} B_{X}(WO₄)₂, wherein A represents yttrium, lutetium, gadolinium or another lanthanide, B represents a lanthanide, preferably ytterbium, and x represents a percentage of atom substitution which varies between 0 and 0.5.

2. High-quality thin monocrystalline layers in accordance with claim 1, **characterized in that** A represents yttrium, lutetium or gadolinium, B represents ytterbium and 0≤x≤0.5.

3. High-quality thin monocrystalline layers in accordance with claims 1 and 2, **characterized in that** A represents yttrium, B represents ytterbium and x = 0.2.

4. Process for the production of high-quality thin monocrystalline layers according to claims 1-3, **characterized in that** comprises the following stages:
a) producing a crystal which serves as monocrystalline substrate for epitaxial growth and cleaning it
b) preparing a growth solution of double tungstate of formula KA_{1-X} B_{X}(WO₄)₂ dissolved in K₂W₂O₇, preferably in the solute/solvent proportion of 5/95 and subjecting it to a practically zero thermal gradient in a free-standing growth oven,
c) immersing the crystal or a sheet of the crystal of stage a), previously reheated, in the growth solution of stage b), which is found at a temperature slightly above that of saturation.
d) decreasing the temperature of the solution to produce epitaxial growth, so that high-quality thin monocrystalline layers are obtained.

5. Process in accordance with claim 4, **characterized in that** the production of the crystal of stage a) comprises:
i) preparing a growth solution for the substrate in a solute/solvent ratio of preferably 12/88 and subjecting it to an axial thermal gradient of 1 K/cm in a growth oven,
ii) introducing a crystal seed in the solution of stage i) at a temperature slightly higher than the expected saturation temperature,
iii) gradually cooling the solution at a set rate from the saturation temperature obtained, so that the crystal grows.

6. Process in accordance with claim 5, **characterized in that** the growth solution for the substrate comprises K₂CO₃, WO₃ as reagents and a reagent selected from between Y₂O₃, Lu₂O₃ or Gd₂O₃ and K₂W₂O₇ as solvent.

7. Process in accordance with claims 5 and 6, **characterized in that** during stage iii) the crystal seed is given rotation movement of 40 rpm.

8. Process in accordance with claims 5-7, **characterized in that** the cooling rate is preferably 0.1 K/h during the first two degrees, to later set a rate of 0.05 K/h until decreasing the desired degrees.

9. Process in accordance with claims 5-8, **characterized in that** the crystal produced is KY(WO₄)₂, KLu(WO₄)₂ or KGd(WO₄)₂.

10. Process in accordance with claims 4 to 9, **characterized in that** the crystal cleaning of stage a) comprises immersing said crystal in HNO₃:H₂0 (1:1), then in C₂H₅-OH and finally, in distilled water, maintaining the crystal in rotation.

11. Process in accordance with claims 4 to 10, **characterized in that** during stages c) and d) the crystal is given a rotation movement of 40 rpm.

12. Process in accordance with claims 4 to 11, **characterized in that** the growth time of stage d) varies between 1-4 hours depending on the thickness of the layer to be achieved.

13. Process in accordance with claims 4-12, **characterized in that** the high-quality thin monocrystalline layers produced are a double tungstate of formula KA_{1-X} B_{X}(WO₄)₂, wherein A represents yttrium, B represents ytterbium and 0≤x≤0.5

14. Use of the high-quality thin monocrystalline layers in accordance with claims 1-3 for the manufacturing of waveguides and miniaturized thin-disk lasers.
